Europäisches Patentamt

European Patent Office

Office européen des brevets

(19)

(11) Veröffentlichungsnummer : **0 429 717 B1**

(12)

# EUROPÄISCHE PATENTSCHRIFT

(45) Veröffentlichungstag der Patentschrift :
**05.04.95 Patentblatt 95/14**

(51) Int. Cl.$^6$ : **H03F 3/45**, H03F 1/32

(21) Anmeldenummer : **89122203.6**

(22) Anmeldetag : **01.12.89**

(54) **Transkonduktanzverstärker.**

(43) Veröffentlichungstag der Anmeldung :
**05.06.91 Patentblatt 91/23**

(45) Bekanntmachung des Hinweises auf die
Patenterteilung :
**05.04.95 Patentblatt 95/14**

(84) Benannte Vertragsstaaten :
**DE FR GB IT NL**

(56) Entgegenhaltungen :
EP-A- 0 234 655
DE-A- 3 243 145
US-A- 4 901 031
PATENT ABSTRACTS OF JAPAN vol. 5, no.
163 (E-78)(835) 20 Oktober 1981, & JP-A-56
93405 (HITACHI SEISAKUSHO K.K.) 29 Juli
1981,

(56) Entgegenhaltungen :
RADIO FERNSEHEN ELEKTRONIK. vol. 34, no.
5, Mai 1985, BERLIN DD Seite 333″ Tridifferenzverstärker″
PATENT ABSTRACTS OF JAPAN vol. 12, no.
250 (E-633)(3097) 14 Juli 1988, & JP-A-63 38313
(SONY CORP) 18 Februar 1988,
IEEE JOURNAL OF SOLID-STATE CIRCUITS.
vol. sc-19, no. 4, August 1984, NEW YORK US
Seiten 491 - 497; M.OHARA, et al: "Bipolar
Monolithic Amplifiers for a Gigabit Optical Repeater″

(73) Patentinhaber : **Deutsche ITT Industries GmbH**
**Hans-Bunte-Strasse 19**
**D-79108 Freiburg (DE)**

(72) Erfinder : **Theus, Ulrich, Dr. Ing.**
**Schönbergstrasse 5b**
**D-7803 Gundelfingen (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 429 717 B1

## Beschreibung

Ein Transkonduktanzverstärker setzt ein Spannungssignal möglichst linear in ein Stromsignal um, wobei der Ausgang eine möglichst ideale Stromquelle bilden soll. Von Vorteil werden derartige Transkonduktanzverstärker statt Spannungsverstärkern dort verwendet, wo analoge Signale verstärkt oder abgeschwächt werden sollen, beispielsweise bei der Verstärkungsregelung, die kontinuierlich oder in Stufen erfolgen kann. Eine andere Anwendung ist die Um- oder Abschaltung von Signalen, die mit Strömen einfacher als mit Spannungen ist. Transkonduktanzverstärker sind hierbei analogen Multiplizierern vorgeschaltet, die eine Stromweiche aufweisen und von einem Steuersignal gesteuert sind, das ein Extremfall zum Schaltsignal wird.

Eine weitere Anwendung der Transkonduktanzverstärker findet sich häufig bei der Realisierung von Integratoren. In der Regel werden hierbei Ströme mittels eines Kondensators integriert, wobei zuvor die zu integrierenden Spannungssignale in Stromsignale umzuwandeln sind.

In EP-A 0 234 655 werden verschiedene Transkonduktanzverstärker in Bipolartechnik beschrieben, bei denen die Differenz der Ausgangsströme eine lineare Funktion über einen möglichst großen Bereich der Eingangsdifferenzspannung aufweisen soll. Mittels eines vielstufigen, ohmschen Spannungsteilers zwischen den Spannungs-Eingangsklemmen und mittels an den Spannungsabgriffen angeschlossener Transistoren mit unterschiedlich großen Emitterflächen, deren Kollektor-Emitterstrecken parallelgeschaltet sind, wird eine möglichst quadratisch verlaufende Steilheitskennlinie erzeugt. Eine ohmsche Gegenkopplung der einzelnen Transistoren ist dabei nicht vorgesehen. Ebenso sind jeweils mehrere dieser parallelgeschalteten Transistoren über ihre zusammengeschalteten Emitteranschlüsse an eine gemeinsame Stromquelle angeschlossen.

In DE-A 32 43 145 wird ein Differenzverstärker zur Spannungsverstärkung beschrieben, der fest vorgegebene Ruheströme aufweist, deren Wert unabhängig vom Gleichtaktsignal ist. Durch die Verwendung komplementärer Transistoren in Kaskodetechnik in Verbindung mit Gegenkopplungswiderständen und mitlaufenden Stromquellen für die Vorspannungserzeugung sind die Verstärkereigenschaften unempfindlich gegenüber Gleichtaktsignalen. Der beschriebene Differenzverstärker eignet sich daher besonders als monolithisch integrierbarer Operationsverstärker.

Der Aussteuerbereich üblicher Transkonduktanzverstärker wird durch den Wert des Ruhestromes bestimmt, der in der Regel mittig zum Aussteuerbereich liegt. Bei Übersteuerung wird der Ausgangsstrom an der oberen Aussteuerungsgrenze durch den doppelten Wert des Ruhestroms begrenzt und an der unteren Aussteuerungsgrenze durch den zu null gewordenen Strom. Diese Begrenzungen bewirken nichtlineare Verzerrungen, die bekanntlich durch die Entstehung von ungeradzahligen Oberwellen verursacht werden.

Es ist daher Aufgabe der in den Ansprüchen gekennzeichneten Erfindung, einen Transkonduktanzverstärker für Differenzsignale anzugeben, dessen Aussteuerbereich nicht durch den eingestellten Arbeitspunkt begrenzt ist und dessen Klirrfaktor trotz geringer interner Gegenkopplung klein ist.

Die Erfindung und deren Vorteile werden nun anhand der Figuren der Zeichnung näher erläutert:

Fig.1 zeigt schematisch als Schaltung ein einfaches Ausführungsbeispiel der Erfindung,

Fig.2 zeigt ein verbessertes Ausführungsbeispiel und

Fig.3 zeigt den Steilheitsverlauf eines Spannungs-Stromumsetzer als Funktion des Ruhestromes.

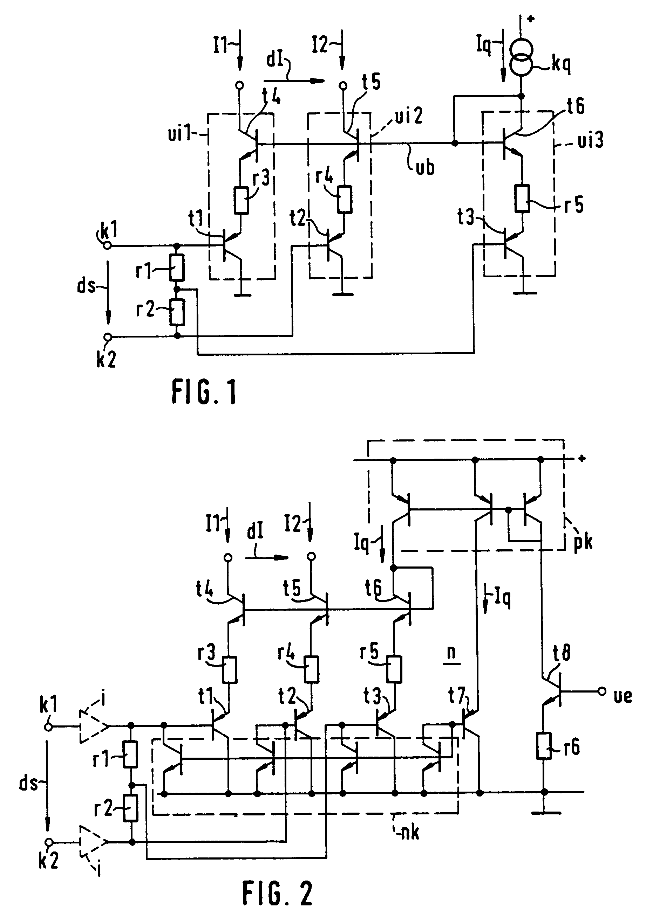

Fig.1 zeigt ein einfaches Ausführungsbeispiel eines Transkonduktanzverstärkers nach der Erfindung. Die Schaltung besteht im wesentlichen aus drei gleichen Spannungs-Stromumsetzern ui1, ui2, ui3 von denen der erste ui1 mit seinem Eingang an eine erste Eingangsklemme k1 und der zweite ui2 an eine zweite Eingangsklemme k2 angeschlossen sind. Beide Eingangsklemmen k1, k2 dienen dem Transkonduktanzverstärker als Eingang für die Differenzspannung ds.

Die drei Spannungs-Stromumsetzer ui1, ui2, ui3 sind monolithisch als Bipolarschaltung auf einem Chip integriert, wobei die guten Paarungseigenschaften der einzelnen Schaltungselemente zum Tragen kommen. Von Vorteil für das Hochfrequenzverhalten ist, daß in den dynamischen Schaltungsteilen nur npn-Transistoren und pnp-Substrattransistoren verwendet werden, jedoch keine lateralen pnp-Transistoren mit ihrer niederen Grenzfrequenz.

Alle Spannungs-Stromumsetzer ui1, ui2, ui3 enthalten in ihrem Eingang einen pnp-Substrattransistor, vgl. den ersten bzw. zweiten bzw. dritten Transistor t1, t2, t3 in Fig. 1. Deren Kollektoren sind durch das Substrat gebildet und deren Emitter sind über einen dritten bzw. vierten bzw. fünften Widerstand r3, r4, r5 jeweils mit dem Emitter eines npn-Transistors verbunden, die in Fig.1 als vierter bzw. fünfter bzw. sechster Transistor t4, t5, t6 dargestellt sind. Die Basisanschlüsse dieser drei npn-Transistoren liegen auf einem gemeinsamen Bezugspotential ub, das durch den dritten Spannungs-Stromumsetzer ui3 und eine Konstantstromquelle kg bestimmt wird.

Der Kollektor des vierten und des fünften Transistors t4, t5 bildet den hochohmigen Differenzausgang des Transkonduktanzverstärkers. Da die Basis des ersten bzw. zweiten Transistors t1, t2 mit der ersten bzw. zweiten Eingangsklemme k1, k2 verbunden ist, hängt der Kollektorstrom des vierten bzw. fünften Transistors t4, t5 vom Potential der ersten bzw. zweiten Eingangsklemme k1, k2 ab. Der Ausgangsstrom der beiden Spannungs-Stromumsetzer folgt dabei dem Potential der zugehörigen Eingangsklemme. Den Stromanstieg begrenzt der dritte bzw. der vierte Widerstand r3, r4 im ersten bzw. zweiten Spannungs-Stromumsetzer ui1, ui2. Ferner geht in die Größe des Ausgangsstromes die differentielle Steilheit $1/U_T$ der beiden in Serie geschalteten Basis-Emitterstrecken in jedem Spannungs-Stromumsetzer ein. Der erste Ausgangsstrom I1 des Transkonduktanzverstärkers ist der Kollektorstrom des vierten Transistors t4 und der zweite Ausgangsstrom I2 ist der Kollektorstrom des fünften Transistors t5.

Die Einstellung des Bezugspotentials ub erfolgt durch den dritten Spannungs-Stromumsetzer ui3, dessen Stromausgang mit dem gemeinsamen Basisanschluß aller drei npn-Transistoren verbunden ist. Der zusammengeschaltete Basis-Kollektoranschluß des sechsten Transistors t6 wird durch die Konstantstromquelle kq mit einem Strom Iq gespeist. Dieser Strom bestimmt zugleich den Ruhestrom Iq des ersten und des zweiten Spannungs-Stromumsetzers ui1, ui2.

Zwischen der ersten und der zweiten Eingangsklemme k1, k2 liegt ein ohmscher Spannungsteiler aus einem ersten und einem zweiten Widerstand r1, r2. Am Mittelabgriff dieses Spannungsteilers ist der Eingang des dritten Spannungs-Stromumsetzers ui3 angeschlossen, also die Basis des dritten Transistors t3.

Liegen die beiden Eingangsklemmen k1, k2 auf gleichem Potential, dann liegt auch der Mittelabgriff des Spannungsteilers r1, r2 auf diesem Potential. Durch alle drei Spannungs-Stromumsetzer ui1, ui2, ui3 fließt in diesem Fall der gleiche Strom Iq, nämlich der Ruhestrom. Liegt eine Differenzspannung ds zwischen den beiden Eingangsklemmen k1, k2, dann ändern sich die beiden Ausgangsströme I1, I2, indem der eine Strom größer und der andere kleiner wird.

Bei streng linearer Abhängigkeit der beiden Ausgangsströme I1, I2 vom Eingangspotential würde der eine Strom um einen Differenzstrom dI größer und der andere um den gleichen Differenzstrom dI kleiner werden - dies würde jedoch, wie bereits beschrieben, zu dem ungewünschten scharfen Begrenzungseinsatz bei Bereichsüberschreitung führen.

Das der Erfindung zugrunde liegende Schaltungskonzept ermöglicht jedoch einen begrenzungsfreien Betrieb auch in demjenigen Bereich, in dem einer der beiden Spannungs-Stromumsetzer ui1, ui2 nahezu stromlos geworden ist. In diesem Bereich wirken sich Änderungen der Differenzspannung ds vorwiegend nur auf einen der Ausgangsströme I1, I2 aus und zwar mit höherer Steilheit als im nicht ausgesteuerten Fall mit I1 = I2. Die Steilheit des Differenzstromes dI bleibt hierdurch nahezu konstant.

Die Wirkungsweise der Erfindung beruht darauf, daß über die Gegenkopplungswide£stände r3, r4, r5 und den Ruhestrom Iq die Steilheit der drei Spannungs-Stromumsetzer ui1, ui2, ui3 so eingestellt wird, daß die Gegenkopplungswirkung der drei Widerstände r3, r4, r5 etwa gleich groß wie die differentielle Steilheit $I/U_T$ der Basis-Emitterstrecke ist. Mit zunehmender Differenzspannung ds nimmt der Ausgangsstrom I1, I2 des einen Spannungs-Stromumsetzers ui1, ui2 und seine Steilheit zu, während der andere Ausgangsstrom I2, I1 und dessen zugehörige Steilheit abnimmt. Beide Wirkungen kompensieren sich hierbei, so daß die Differenz dI des ersten und zweiten Ausgangsstromes I1, I2 weiterhin proportional zum Wert der Differenzspannung ds bleibt.

Der Strom Iq der Konstantstromquelle und damit der Ruhestrom Iq der drei Spannungs-Stromumsetzer ui1, ui2, ui3 und die drei Gegenkopplungswiderstände r3, r4, r5 sind etwa nach folgender Bemessungsregel einzustellen:

$$U_T < Iq \times r < 2U_T$$

wobei r= r3 = r4 = r5 und $U_T$ die Volt-Temperaturspannung ist, die nach der Theorie 26 mV beträgt. Hierdurch bleibt die Gegenkopplungswirkung der drei Widerstände r3, r4, r5 gering. Die niederen Gegenkopplungswiderstände r3, r4, r5 wirken sich auch günstig auf das Rauschverhalten des Transkonduktanzverstärkers aus.

In Fig.2 ist ein verbessertes Ausführungsbeispiel des Transkonduktanzverstärkers nach Fig.1 dargestellt. Um die weitgehende Übereinstimmung der Schaltung nach Fig.2 mit der Schaltung nach Fig.1 zu verdeutlichen, sind gleiche Schaltungsteile mit gleichen Bezugszeichen dargestellt. Die grundsätzliche Funktionsweise ist ebenso übertragbar und wird daher nicht nochmals aufgeführt.

Nachteilig bei der Schaltungsanordnung nach Fig.1 sind die Basisströme des ersten, zweiten und dritten Transistors t1, t2, t3, die die beiden Eingangsklemmen k1, k2 und den Mittelabgriff des ohm'schen Spannungsteilers r1, r2 belasten. Über den Quellenwiderstand der Differenzspannung ds und den Widerstand des Spannungsteilers r1, r2 kann die Differenzspannung ds verfälscht werden, vor allem wird aber durch die Belastung des Spannungsteiler-Mittelabgriffs das Verhältnis der drei Ausgangsströme I1, I2, Iq gestört. Dies wirkt sich selbstverständlich auf die Größe und Genauigkeit des (fiktiven) Differenzstroms dI aus. Dieser läßt sich realisieren, indem beispielsweise der erste und zweite Ausgangsstrom I1, I2 auf den Ein- bzw. Ausgang eines in Fig.1 und 2 nicht dargestellten pnp-Stromspiegels geschaltet werden.

Abhilfe bezüglich der störenden Basisströme wird nach dem verbesserten Ausführungsbeispiel (vgl. Fig. 2) der Erfindung geschaffen, indem die Basisströme der drei npn-Transistoren t1, t2, t3 durch die Ausgangsströme einer npn-Strombank nk kompensiert werden, deren Strom von einer Nachbildungsschaltung n eingestellt wird. Diese ist mit einem Strom Iq angesteuert, der gleichgroß wie der Strom Iq der Konstantstromquelle kq ist.

Als Nachbildung enthält die Nachbildungsschaltung n einen siebten Transistor t7, der den drei pnp-Transistoren t1, t2, t3 genau entspricht und ebenso wie diese als Substrat-pnp-Transistor ausgeführt ist. Der Basisstrom des siebten Transistors t7 speist den Eingang einer dreistufigen npn-Strombank, deren drei Ausgänge auf die Basisanschlüsse der drei pnp-Transistoren t1, t2, t3 geführt sind.

Der dritte Spannungs-Stromumsetzer ui3 und die Nachbildungsschaltung n werden jeweils mit dem Konstantstrom Iq gespeist. Diese Ströme Iq liefert beispielsweise eine zweistufige pnp-Strombank pk deren Eingang mit dem Kollektor eines achten Transistors t8, eines npn-Transistors, verbunden ist, dessen Emitter über einen sechsten Widerstand r6 auf das Massepotential geschaltet ist. Über die an die Basis des achten Transistors t8 gelegte Spannungen ue wird der Strom der pnp-Strombank pk und damit der Ruhestrom des Transkonduktanzverstärkers eingestellt.

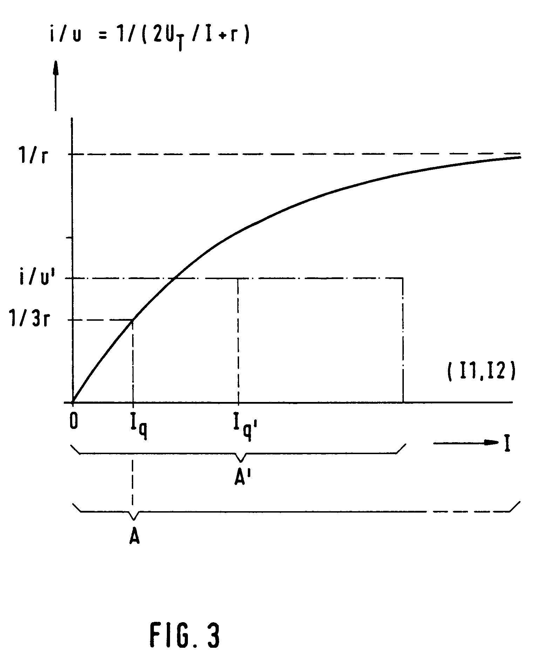

In Fig.3 ist schematisch die Steilheit i/u der drei Spannungs-Stromumsetzer ui1, ui2, ui3 als Funktion des Ausgangsstromes I dargestellt. Nach der angegebenen Bemessungsregel gilt für die Steilheit i/u folgende Beziehung, wenn r beispielsweise $r = U_T/I_q$ ist:

$$i/u = 1/( 2U_T/I + r)$$

Bei großen Strömen I ist die Steilheit $i/u = 1/r$, also ein konstanter Wert, der nur noch vom jeweiligen Gegenkopplungswiderstand r abhängig ist. Bei kleinen Strömen I ist die Steilheit $i/u = I/2U_T$, also nur noch von der differentiellen Steilheit $I/U_T$ der beiden Basis-Emitterstrecken, nicht jedoch vom Gegenkopplungswiderstand r, abhängig. Beim angegebenen Ruhestrom Iq ist die Steilheit $i/u = 1/3r$. Der Aussteuerbereich A' kann sich beliebig weit in den Bereich großer Ströme erstrecken, weil dort die Steilheit i/u konstant bleibt. Damit bleibt der Differenzstrom dI ebenfalls proportional zur Differenzspannung ds. Der relativ niedere Ruhestrom Iq bewirkt auch eine geringe Leistungsaufnahme. Die strichpunktierte Linie stellt den üblichen konstanten Steilheitsverlauf i/u' mit symmetrischem Aussteuerbereich A' und höherem Ruhestrom Iq' dar.

## Patentansprüche

1. Transkonduktanzverstärker, mit folgenden Merkmalen
   - eine von einer Differenzspannung (ds) angesteuerte Eingangsdifferenzstufe weist zwei Eingangsklemmen auf, deren erste (k1) mit einem ersten Spannungs-Stromumsetzer (ui1) und deren zweite (k2) mit einem zum ersten gleichen zweiten Spannungs-Stromumsetzer (ui2) gekoppelt sind,
   - ein zum ersten und zweiten Spannungs-Stromumsetzer (ui1, ui2) gleicher dritter Spannungs-Stromumsetzer (ui3) liegt mit einer Eingangsklemme am Mittelabgriff eines ohm'schen Spannungsteilers (r1, r2), der zwischen der ersten und der zweiten Eingangsklemme angeschlossen ist,
   - als Transkonduktanzverstärker-Ausgangssignal liefert der Stromquellenausgang des ersten und des zweiten Spannungs-Stromumsetzers (ui1, ui2) einen ersten bzw. einen zweiten Ausgangsstrom (I1, I2), deren Differenzstrom (dI) proportional zur Größe der Differenzspannung (ds) ist, gekennzeichnet durch folgende weitere Merkmale :
   - die Steilheitsverläufe des ersten, zweiten und dritten Spannungs-Stromumsetzers (ui1, ui2, ui3) sind einander gleich und setzen sich aus einem stromabhängigen Anteil und einem ohmschen Gegenkopplungsanteil zusammen, wobei der Ruhewert der Steilheit jeweils mittels eines Gegenkopplungswiderstandes (r3, r4, r5; r) und eines Ruhestromes (Iq) so eingestellt ist, daß der stromabhängige Anteil der Steilheit gegenüber dem ohmschen Anteil gleich oder größer ist,
   - die Potentialanschlüsse für die jeweilige Ruhestromeinstellung der drei Spannungs-Stromumsetzer (ui1, ui2, ui3) liegen gemeinsam auf einem Ruhestrom-Einstellpotential (ub), das durch den dritten Spannungs-Stromumsetzer (ui3) gebildet ist, dessen Ausgangsstrom von einer Konstantstromquelle (kq) vorgegeben ist.

2. Transkonduktanzverstärker nach Anspruch 1, dadurch gekennzeichnet, daß der erste bzw zweite bzw. dritte Spannungs-Stromumsetzer (ui1, ui2, ui3) in seinem jeweiligen Steuereingang einen ersten bzw. einen zweiten bzw. einen dritten Transistor (t1, t2, t3) enthält, dessen Basisanschluß den jeweiligen Steuereingang bildet.

3. Transkonduktanzverstärker nach Anspruch 2, dadurch gekennzeichnet, daß eine Nachbildungsschaltung (n) drei gleiche Ströme erzeugt, die jeweils entgegengesetzt gleich dem Basisstrom des ersten bzw. zweiten bzw. dritten Transistors (t1, t2, t3) sind und die jeweils zur Kompensation des Basisstromes auf den Basisanschluß des ersten bzw. zweiten bzw. dritten Transistors (t1 t2 t3) geschaltet sind.

4. Transkonduktanzverstärker nach Anspruch 3, dadurch gekennzeichnet, daß der erste bzw. zweite bzw. dritte Spannungs-Stromumsetzer (ui1, ui2, ui3) einen vierten bzw. einen fünften bzw. einen sechsten Transistor (t4, t5, t6) von entgegengesetzter Polarität wie der erste, zweite und dritte Transistor (t1, t2, t3) enthält, daß der Emitter des vierten bzw. fünften bzw. sechsten Transistors (t4, t5, t6) über einen dritten bzw. einen vierten bzw. einen fünften Widerstand (r3, r4, r5) mit dem Emitter des ersten bzw. zweiten bzw. dritten Transistors (t1, t2, t3) verbunden ist, wobei die Basisanschlüsse des vierten, fünften und sechsten Transistors (t4, t5, t6) an das gemeinsame Ruhestrom einstellpotential (ub) angeschlossen sind.

5. Transkonduktanzverstärker nach Anspruch 4, dadurch gekennzeichnet, daß die Konstantstromquelle (kq) durch einen ersten Ausgang einer pnp-Strombank (pk) gebildet ist, deren zweiter Ausgang den Eingang der Nachbildungsschaltung (n) speist, die als Nachbildung des ersten, zweiten und dritten Transistors t1, t2, t3 einen siebten Transistor (t7) vom gleichen Typ wie der erste, zweite und dritte Transistor (t1, t2, t3) enthält und daß der Basisstrom des siebten Transistors (t7) auf den Eingang einer npn-Strombank (nk) geführt ist, die über jeweils einen Ausgang mit dem Basisanschluß des ersten bzw. zweiten bzw. dritten Transistors (t1, t2, t3) verbunden ist, wobei der erste, zweite, dritte und siebte Transistor (t1, t2, t3, t7) jeweils ein pnp-Substrattransistor und der vierte, fünfte und sechste Transistor (t4, t5, t6) jeweils ein npn-Transistor ist.

6. Transkonduktanzverstärker nach Anspruch 1, dadurch gekennzeichnet, daß die Gegenkopplungswiderstände (r3, r4, r5; r) und der Ruhestrom (Iq) nach folgender Bemessungsregel eingestellt sind:

$$U_T < Iq \times r < 2U_T,$$

wobei r = r3 = r4 = r5 ist.

7. Transkonduktanzverstärker nach einem der Ansprüche 1 bis 6, dadurch gekennzeichnet, daß die erste und die zweite Eingangsklemme (k1, k2) jeweils durch eine Impedanzwandlerschaltung (i) von der Eingangsdifferenzstufe entkoppelt sind.

**Claims**

1. A transconductance amplifier with the following features:
   - A differential-input stage driven by a difference voltage (ds) has two input terminals the first of which (k1) is coupled to a first voltage-to-current converter (ui1), and the second of which (k2) is coupled to a second voltage-to-current converter (ui2) which is identical to the first voltage-to-current converter.
   - a third voltage-to-current converter (ui3) identical to the first and second voltage-to-current converters (ui1, ui2) has its input terminal coupled to the tap of a resistive voltage divider (r1, r2) connected between the first and second input terminals, and
   - the current source outputs of the first and second voltage-to-current converters (ui1, ui2) deliver, as a transconductance amplifier output signal, a first output current (I1) and a second output current (I2) whose difference current is proportional to the value of the difference voltage (ds), characterized by the following features:
   - The transconductance characteristics of the first, second, and third voltage-to-current converters (ui1, ui2, ui3) are identical and are composed of a current-dependent component and a resistive negative-feedback component, with the quiescent value of the transconductance set by means of a respective negative-feedback resistor (r3, r4, r5; r) and a quiescent current (Iq) so that the current-dependent component of the transconductance is equal to or greater than the resistive component, and
   - the potential terminals for setting the respective quiescent currents of the three voltage-to-current converters (ui1, ui2, ui3) are at a common quiescent-current-setting potential (up) which is implemented by the third voltage-to-current converter (ui3), whose output current is determined by a constant-current source (kq).

2. A transconductance amplifier as claimed in claim 1, characterized in that the first, second, and third voltage-to-current converters (ui1, ui2, ui3) have in their control inputs a first transistor (t1), a second transistor (t2), and a third transistor (t3), respectively, whose base terminals constitute the respective control inputs.

3. A transconductance amplifier as claimed in claim 2, characterized in that a simulating circuit (n) generates three equal currents which are equal in value but opposite in sign to the base currents of the first, second, and third transistors (t1, t2, t3), respectively, and are supplied to the base terminals of the first, second, and third transistors (t1, t2, t3) to compensate the base currents.

4. A transconductance amplifier as claimed in claim 3, characterized in that the first, second, and third voltage-to-current converters (ui1, ui2, ui3) include a fourth transistor (t4), a fifth transistor (t5), and a sixth transistor (t6), respectively, which are of opposite polarity to the first, second, and third transistors (t1, t2, t3), that the emitters of the fourth, fifth, and sixth transistors (t4, t5, t6) are connected via third, fourth, and fifth resistors (r3, r4, r5) to the emitters of the first, second, and third transistors (t1, t2, t3), respectively, with the base terminals of the fourth, fifth, and sixth transistors (t4, t5, t6) connected to the common quiescent-current-setting potential (ub).

5. A transconductance amplifier as claimed in claim 4, characterized in that the constant-current source (kq) is formed by a first output of a pnp current bank (pk) whose second output feeds the input of the simulating circuit (n), which contains a seventh transistor (t7) which is of the same type as, and serves as a replica of, the first, second, and third transistors (t1, t2, t3), and that the base current of the seventh transistor (t7) is supplied to the input of an npn current bank (nk) having three outputs connected to the base terminals of the first, second, and third transistors (t1, t2, t3), respectively, the first, second, third, and seventh transistors (t1, t2, t3, t7) being substrate-pnp transistors, and the fourth, fifth, and sixth transistors (t4, t5, t6) being npn transistors.

6. A transconductance amplifier as claimed in claim 7, characterized in that the values of the feedback resistors (r3, r4, r5; r) and the quiescent current (Iq) are chosen according to the following rule:
$$U_T < Iq \times r < 2U_T ,$$
where r = r3 = r4 = r5.

7. A transconductance amplifier as claimed in any one of claims 1 to 6, characterized in that the first and second input terminals (k1, k2) are each buffered from the differential-input stage by an impedance transformer (i).

**Revendications**

1. Amplificateur à transconductance, comportant les particularités suivantes :
   - un étage différentiel d'entrée, commandé au moyen d'une tension différentielle (ds), comporte deux bornes d'entrée dont la première (k1) est couplée à un premier convertisseur tension-courant (ui1) et dont la seconde (k2) est couplée à un deuxième convertisseur tension-courant (ui2),
   - un troisième convertisseur tension-courant (ui3), identique au premier et au deuxième convertisseurs tension-courant (ui1, ui2), est relié par une borne d'entrée à la prise intermédiaire d'un diviseur de tension de type ohmique (r1, r2) qui est branché entre la première et la seconde bornes d'entrée,
   - comme signal de sortie de l'amplificateur à transconductance, les sorties de source de courant du premier et du deuxième convertisseurs tension-courant (ui1, ui2) fournissent respectivement un premier et un second courants de sortie (I1, I2) dont la différence de courant dI est proportionnelle à la valeur de la tension différentielle (ds),
   caractérisé par les particularités supplémentaires suivantes :
   - les profils de variation de pente du premier, du deuxième et du troisième convertisseurs tension-courant (ui1, ui2, ui3) sont identiques l'un à l'autre et se composent d'une partie dépendant du courant et d'une partie de contre-réaction de type ohmique, la valeur de repos de chaque pente étant réglée au préalable, au moyen d'une résistance de contre-réaction (r3, r4, r5 ; r) associée et d'un courant de repos (Iq) d'une façon telle que la partie de la pente qui dépend du courant est égale ou supérieure à la partie ohmique,
   - les connexions de potentiel servant au réglage préalable du courant de repos de chacun des trois convertisseurs tension-courant (ui1, ui2, ui3) sont en commun à un potentiel (ub) de réglage préalable de courant de repos qui est constitué par le troisième convertisseur tension-courant (ui3) dont le courant de sortie est prédéterminé au moyen d'une source de courant constant (kq).

2. Amplificateur à transconductance selon la revendication 1, caractérisé en ce que le premier, le deuxième et le troisième convertisseurs tension-courant (ui1, ui2, ui3) comportent, respectivement à l'entrée de chacun, un premier, un deuxième et un troisième transistors (t1, t2, t3) dont la connexion de la base constitue l'entrée de commande respective.

3. Amplificateur à transconductance selon la revendication 2, caractérisé en ce qu'un circuit d'équilibrage (n) produit trois courants identiques dont chacun est égal et de signe opposé au courant de base du premier, du deuxième ou du troisième transistor (t1, t2, t3) associé et dont chacun est appliqué, pour compenser le courant de base, à la connexion de base du premier, du deuxième ou du troisième transistor (t1, t2, t3) associé.

4. Amplificateur à transconductance selon la revendication 3, caracrérisé en ce que le premier, le deuxième et le troisième convertisseurs tension-courant (ui1, ui2, ui3) comportent respectivement un quatrième, un cinquième et un sixième transistor (t4, t5, t6) de polarité opposée à celle du premier du deuxième ou du troisième transistor (t1, t2, t3) associé et en ce que les émetteurs du quatrième, du cinquième et du sixième transistors (t4, t5, t6) sont reliés respectivement aux émetteurs du premier, du deuxième et du troisième transistors (t1, t2, t3) par l'intermédiaire respectivement d'une troisième, d'une quatrième et d'une cinquième résistance (r3, r4, r5), tandis que les connexions de base du quatrième, du cinquième et du sixième transistors (t4, t5, t6) sont branchées chacune sur le potentiel commun (ub) de réglage préalable de courant de repos.

5. Amplificateur à transconductance selon la revendication 4, caractérisé en ce que la source de courant constant (kq) est constituée par une première sortie d'une banque de courant PNP (pk) dont une seconde sortie alimente l'entrée du circuit d'équilibrage (n) qui, comme élément d'équilibrage du premier, du deuxième et du troisième transistors (t1, t2, t3), comprend un septième transistor (t7) du même type que le premier, le deuxième et le troisième transistors (t1, t2, t3) et en ce que le courant de base du septième transistor (t7) est appliqué à l'entrée d'une banque de courants NPN (nk) qui est reliée par des sorties respectives aux connexions de base du premier, du deuxième et du troisième transistors (t1, t2, t3) associés, tandis que chacun des premier, deuxième, troisième et septième transistors (t1, t2, t3, t7) est un transistor PNP à substrat et chacun des quatrième, cinquième et sixième transistors (t4, t5, t6) est un transistor NPN.

6. Amplificateur à transconductance selon la revendication 1, caractérisé en ce que les résistances de contre-réaction (r3, r4, r5 ; r) et le courant de repos (Iq) sont réglés au préalable suivant la règle suivante de calcul :
$$U_T < I_q \times r < 2U_T$$
dans laquelle r = r3 = r4 = r5.

7. Amplificateur à transconductance selon l'une des revendications 1 à 6, caractérisé en ce que la première et la seconde bornes d'entrée (k1, k2) sont découplées de l'étage différentiel d'entrée au moyen d'un circuit adaptateur d'impédance (i).

FIG. 1

FIG. 2

$$i/u = 1/(2U_T/I + r)$$

FIG. 3